# EUROPÄISCHE PATENTANMELDUNG

(11) **EP 2 290 385 A1**
(43) Veröffentlichungstag der Anmeldung: **02.03.2011**
(21) Anmeldenummer: 09010847.3
(22) Anmeldetag: 25.08.2009
(51) Int. Cl.: G01R 31/12, G01R 31/14

(54) **Überwachungssystem für Leistungstransformatoren und Überwachungsverfahren**

(71) Anmelder: ABB Technology AG, 8050 Zürich (CH)
(72) Erfinder: Werle, Peter, 29664 Walsrode (DE); Szczechowski, Janusz, 04229 Leipzig (DE); Koch, Norbert, 8953 Dietikon (CH)
(74) Vertreter: Miller, Toivo

(57) **Zusammenfassung**

Die Erfindung betrifft ein Überwachungssystem für Leistungstransformatoren (12) mit wenigstens einer Messvorrichtung (58) zur kontinuierlichen Erfassung eines Spannungssignals (U'(t), U1'(t), U2'(t), U3'(t), 100, 110), welche in einer Durchführung (14, 16, 18, 50) des Leistungstransformators (12) integriert ist, und mit wenigstens einer Auswertevorrichtung (20, 78, 94) zur Analyse wenigstens des Spannungssignals (U'(t), U1'(t), U2'(t), U3'(t), 100, 110). Die Auswertevorrichtung (20, 78, 94) weist wenigstens eine erste (22, E1, E3, E5) und eine zweite (24, E2, E4, E6) unabhängige Erfassungsvorrichtung für das dieser über wenigstens eine Verbindungsleitung (26, 72, 74, 76) jeweils zugeführte Spannungssignal (U'(t), U1'(t), U2'(t), U3'(t), 100, 110) auf. Wenigstens eine erste Teilauswertevorrichtung (30, T1, T3, T5) für eine Spannungssignalanalyse in einem ersten Frequenzbereich ist mit der ersten Erfassungsvorrichtung (22, E1, E3, E5) verbunden und wenigstens eine zweite Teilauswertevorrichtung (32, T2, T4, T6) für eine Spannungssignalanalyse in einem zweiten Frequenzbereich ist mit der zweiten Erfassungsvorrichtung (24, E2, E4, E6) verbunden. In der Verbindungsleitung (26, 72, 74, 76) ist wenigstens eine Abzweigung (28) mit nachgeschaltetem Analogfilter (46, 48, F1, F2, F3, F4, F5, F6) vorgesehen, welcher das jeweilige Frequenzband des der jeweiligen Erfassungsvorrichtung (22, 24, E1, E2, E3, E4, E5, E6) zugeführten Spannungssignals (U'(t), U1'(t), U2'(t), U3'(t), 100, 110) individuell begrenzt.

## Beschreibung

Die Erfindung betrifft ein Überwachungssystem für Leistungstransformatoren, mit wenigstens einer Messvorrichtung zur kontinuierlichen Erfassung eines Spannungssignals, welche in einer Durchführung des Leistungstransformators integriert ist, und mit wenigstens einer Auswertevorrichtung zur Analyse wenigstens des Spannungssignals. Die Erfindung betrifft auch ein entsprechendes Überwachungsverfahren.

Es ist allgemein bekannt, dass Leistungstransformatoren in Energieverteilungsnetzen, beispielsweise mit einer Nennleistung von einigen MVA bis einigen 100 MVA und einer Nennspannung zwischen 10kV und 400kV, einem langsam fortschreitenden Alterungsprozess unterworfen sind, durch welchen beispielsweise auch die Funktionsfähigkeit der elektrischen Isolation innerhalb des Leistungstransformators punktuell im eingeschränkt ist. Dies führt dann unter Umständen zu sogenannten Teilentladungen, also elektrischen Teildurchschlägen in einer Hochspannungsisolierungen bei örtlicher Überschreitung der materialtypischen Durchschlagfeldstärke. Solche Teilentladungen (abgekürzt auch als "TE" bezeichnet) treten vor allem bei Beanspruchung der Isolierung mit Wechselspannung auf und führen zu Spannungsimpulsen von wenigen µs an der Klemmenspannung des Leistungstransformators.

Das Auftreten von Teilentladungen führt nicht notwendigerweise zu einer Funktionsuntüchtigkeit des Leistungstransformators, ist jedoch sowohl ein Indikator für einen erhöhten Alterungszustand der Isolation als auch ein Indikator für eine erhöhte Belastung der Isolation, welcher deren Alterung beschleunigt.

Weitere Indikatoren für eine Belastung oder den Zustand des Transformators sind beispielsweise das Auftreten von Blitzüberspannungen oder auch von harmonischen Überspannungen, wobei insbesondere die harmonischen Oberschwingungen in einem deutlich längeren Zeitbereich als Teilentladungen auftreten, beispielsweise in Form einer eine 10. Harmonischen mit einer Periodenlänge von 2ms. Hierbei ist zwischen Oberschwingungen zu unterscheiden, welche aufgrund eines möglichen Fehlers innerhalb des Leistungstransformators selbst auftreten und solchen, welche über das elektrische Energieverteilungsnetz in den Leistungstransformator eingekoppelt werden.

Derartige Indikatoren sind, wie auch die Messung des tan Δ, also eines Verlustwinkels, geeignet zur Ermittlung des aktuellen Zustandes des Transformators, zur Bestimmung von eventuellen Transformatorfehlern und eines daraus eventuell resultierenden Wartungsbedarfs, was dem Fachmann jedoch bekannt ist. Solche Indikatoren sind aber ebenso geeignet für eine Ermittlung des Wartungsbedarfes anhand beispielsweise der über einen Zeitraum - beispielsweise mehrere Jahre - akkumulierten Belastungen des Leistungstransformators.

Die meisten Indikatoren lassen sich bereits aus einem oder mehreren Spannungssignalen ableiten, für einige Analysen, beispielsweise der Bestimmung des Verlustwinkels, ist zudem noch die Erfassung eines Stromsignals notwendig. Die Ergebnisse von den genannten Analysen sind zu Diagnostik- und Wartungszwecken des Transformators von hoher Bedeutung. Die Erfassung der Spannungssignale erfolgt üblicherweise mittels in den Transformatordurchführungen integrierter kapazitiver Spannungsteiler, welche ursächlich zur Potentialsteuerung vorgesehen sind.

Nachteilig hierbei ist, dass vorhandene Analyse- bzw. Überwachungssysteme zumeist lediglich im Rahmen einer provisorischen Prüfanordnung für Laborzwecke bereitgestellt sind und zudem jeweils nur für einen einzigen Analysezweck vorgesehen sind, wobei üblicherweise lediglich ein einziger Messanschluss am Spannungsteiler einer Transformatordurchführung vorhanden ist.

Ausgehend von diesem Stand der Technik ist es Aufgabe der Erfindung, ein Überwachsungssystem und ein Verfahren für eine verbesserte Überwachung von Leistungstransformatoren anzugeben.

Diese Aufgabe wird gelöst durch ein Überwachsungssystem für Leistungstransformatoren der eingangs genannten Art. Dieses ist **dadurch gekennzeichnet, dass** die Auswertevorrichtung wenigstens eine erste und eine zweite unabhängige Erfassungsvorrichtung für das dieser über wenigstens eine Verbindungsleitung jeweils zugeführte Spannungssignal aufweist, dass wenigstens eine erste Teilauswertevorrichtung für eine Spannungssignalanalyse in einem ersten Frequenzbereich mit der ersten Erfassungsvorrichtung verbunden ist, dass wenigstens eine zweite Teilauswertevorrichtung für eine Spannungssignalanalyse in einem zweiten Frequenzbereich mit der zweiten Erfassungsvorrichtung verbunden ist und dass in der Verbindungsleitung wenigstens eine Abzweigung mit nachgeschaltetem Analogfilter vorgesehen ist, welcher das jeweilige Frequenzband des der jeweiligen Erfassungsvorrichtung zugeführten Spannungssignals individuell begrenzt.

Der Erfindung liegt der Gedanke zugrunde, ein Überwachungssystem für die kontinuierliche Analyse insbesondere der Spannung eines Leistungstransformators anzugeben, welches mehrere zeitgleiche Analysemöglichkeiten für verschiedene Indikatoren des Transformatorzustandes und damit auch eine verbesserte Gesamtanalyse ermöglicht.

Hierbei wird erfindungsgemäß vorgeschlagen, eine Erfassung der Spannungssignale aus einem Messwandler einer Transformatordurchführung nicht mit einer einzigen Erfassungsvorrichtung, beispielsweise einem Analog- Digitalwandler (A/D Wandler), durchzuführen, sondern vielmehr getrennte Erfassungsvorrichtungen für jeweilige Analysearten vorzusehen. Die Verwendung eines Messwandlers, welcher in ein ohnehin bei einem Leistungstransformator vorhandenes Bauteil wie eine Durchführung integriert ist, vermeidet vorteilhaft zusätzliche Messkomponenten. Die Anforderungen an die Erfassungsvorrichtungen hängen nämlich in hohem Maße von der Art einer durchzuführenden Analyse oder Auswertung des Spannungssignals ab. Während beispielsweise eine harmonische Oberschwingung eines Spannungssignals eine Periodenlänge von beispielsweise einer Millisekunde aufweist, liegt die zeitliche Länge eines Teilentladungsimpulses bei wenigen Mikrosekunden, womit eine geeignete Abtastrate für eine A/D Wandlung im erstgenannten Fall bei wenigstens ca. 10kHz liegt und im zweitgenannten Fall bei wenigstens einigen MHz.

Erfindungsgemäß ist fernerhin wenigstens eine Abzweigung in der Verbindungsleitung mit nachgeschaltetem Analogfilter vorgesehen, mit welchem das Frequenzband des abgezweigten Spannungssignals an den für eine jeweilige Auswertung durch eine Teilauswertevorrichtung relevanten Bereich beschränkt ist. Die Genauigkeit des Analyseergebnisses ist somit durch das Herausfiltern nicht-relevanter Information in vorteilhafter Weise gesteigert.

Die Bereitstellung von mehreren gleichzeitig aktivierbaren Analysefunktionalitäten in einer einzigen Auswertevorrichtung mit jeweils getrennten Erfassungs- und Filtermöglichkeiten für das zu analysierende Spannungssignal ermöglicht durch die Diversität der Analyse- bzw. Teilauswertvorrichtungen eine vorteilhafte verbesserte Gesamtanalyse ein und desselben Signals. Einer für eine separate Auswertung bzw. Analyse vorgesehenen Teilauswertevorrichtung wird kontinuierlich und synchron das Spannungssignal in einer jeweils derart aufbereiteten und erfassten Form, insbesondere auch bezüglich des Frequenzbereiches, zugeführt, welche für den jeweiligen Analysezweck am besten geeignet ist.

In vorteilhafter Weise ist zudem eine zeitliche Korrelation zwischen den Analyseergebnissen der verschiedenen Teilauswertevorrichtungen ermöglicht, welche wiederum eine noch genauere Überwachung beziehungsweise Fehlerbestimmung ermöglichen.

Eine Anordnung der Teilauswertevorrichtungen und Erfassungsvorrichtungen in einem vorzugsweise gemeinsamen Gehäuse ermöglicht dabei in besonders geeigneter Weise eine dauerhafte und nicht-provisorische Verwendung des Überwachungssystems im Feld.

In einer bevorzugten Ausgestaltung des erfindungsgemäßen Überwachungssystems ist jeder Erfassungsvorrichtung jeweils ein individueller Analogfilter zugeordnet, welcher das jeweilige Frequenzband jedes jeweils zugeführten Spannungssignals individuell begrenzt. Somit ist die Genauigkeit aller Analyseergebnisse noch weiter gesteigert.

Eine Erfassungsvorrichtung, welche ein analoges Messsignal einer zu analysierenden Spannung erfasst und in eine für eine Teilauswertevorrichtung geeignete Form umwandelt, weist in bevorzugter Weise einen Analog- Digitalwandler auf. In einer digitalisierten Form ist ein Spannungssignal besonders geeignet, einer Rechenvorrichtung, beispielsweise einem Personalcomputer, zur weiteren Verarbeitung zugeführt zu werden, welcher in diesem Fall als Teilauswertevorrichtung verwendet ist.

In einer Variante des erfindungsgemäßen Überwachungssystems ist die erste Teilauswertevorrichtung wenigstens für eine Analyse der harmonischen Oberschwingungen einer Spannung vorgesehen, wobei der zugehörige Analogfilter einen Bandpass für etwa 1 kHz bis 50kHz darstellt. Der genannte Frequenzbereich ist besonders relevant für die Analyse von auftretenden Oberschwingungen, welche bis etwa zur 50. Harmonischen besonders relevant sind. Eine für einen Analog- Digitalwandler wenigstens notwendige Abtastfrequenz liegt bei wenigstens dem zwei- bis vierfachen der Frequenz der zu erfassenden Spannung, also bei wenigstens 100kHz bis 200kHz bei einer Nutzfrequenz von 50kHz. Bedarfsweise ist der Analogfilter auch lediglich als Tiefpass für die obere Grenze des genannten Frequenzbereichs auszuführen, welche je nach Randbedingungen auch variieren kann.

In einer weiteren Variante des erfindungsgemäßen Überwachungssystems ist die zweite Teilauswertevorrichtung wenigstens für eine Teilentladungs-Analyse vorgesehen, wobei der zugehörige Analogfilter einen Bandpass für etwa 100kHz bis 2MHz darstellt. Dieser Frequenzbereich ist für die Analyse einer Teilentladungsmessung von besonders hohem Interesse, wobei auch hier Variationen möglich sind.

In einer weiteren Ausgestaltung des Überwachungssystems ist wenigstens eine Signalanpassvorrichtung zwischen Messanschluss der Transformatordurchführung und jeweiliger Erfassungsvorrichtung zwischengeschaltet. Diese ermöglicht beispielsweise eine Verstärkung bzw. Abschwächung des jeweiligen Spannungssignals, womit es genau an die Anforderungen der Erfassungsvorrichtung anpassbar ist, beispielsweise mit einer Amplitude von +/-10V.

Entsprechend einer weiteren besonders bevorzugten Ausprägung des erfindungsgemäßen Überwachsungssystems ist eine weitere Teilauswertevorrichtung dafür vorgesehen, die Ergebnisse von wenigstens zwei Teilauswerteeinrichtungen in einer zeitlichen Korrelation auszuwerten. Eine derartige zeitliche Korrelation ermöglicht die Ermittlung eines verbesserten Gesamtanalyseergebnisses.

Wenn beispielsweise eine Teilauswertevorrichtung für Überspannungen einen Blitzspannungsimpuls detektiert und eine weitere Teilauswertevorrichtungen für harmonische Oberschwingungen ab diesem Moment dauerhaft eine erhöhte dritte Oberschwingung, so ist aus jeder Einzelinformation zwar durchaus eine nutzbare Information entnehmbar, der Rückschluss, dass eben diese Blitzüberspannung adäquat kausal verantwortlich für einen inneren Transformatorfehler sein könnte, durch welchen die Oberschwingungen verursacht sind, ist aber nur mit einer zeitlichen Korrelation der Ergebnisse der Teilauswertevorrichtungen möglich. Hierdurch wird beispielsweise die Bestimmung bzw. Eingrenzung eines möglichen Transformatorfehlers verbessert.

Gemäß einer weiteren Variante des erfindungsgemäßen Überwachsungssystems ist der weiteren Teilauswertevorrichtung zusätzlich ein Messsignal einer weiteren Messvorrichtung zur Auswertung bereitgestellt ist, welches den zeitlichen Verlauf einer nicht-spannungsbezogenen Messgröße beschreibt, beispielsweise einer Vibration einer Temperatur und/oder eines Stromes. Hierdurch werden in vorteilhafter Weise weitere Korrelationen ermöglicht, beispielsweise zwischen einem erhöhten Kurzschlussstrom und einer möglichen Vibration.

In einer weiteren Variante des Überwachsungssystems ist dieses mehrfach für jeweils eine verschiedene Phase eines Drehstromnetzes ausgeführt. Drehstromnetze weisen drei einzelne Phasen auf, wobei Strom und Spannung der drei Phasen sich im symmetrischen Netzbetrieb bei phasenrichtiger Addition jeweils zu Null addieren. Ein deutliches Auftreten einer derartigen sogenannten Nullspannung ist ein Indiz für einen möglichen Fehler im Netz bzw. im Trafo. Durch ein jeweiliges Überwachungssystem für jede der drei Phasen ist eine Korrelation der Einzelanalyseergebnisse der drei Phasen ermöglicht, wodurch die Genauigkeit eines Gesamtanalyseergebnisses weiter gesteigert ist.

Entsprechend einer weiteren Ausführungsform des Überwachungssystems ist wenigstens eine Teilauswertevorrichtung zusätzlich mit wenigstens einem Digitalfilter für eine weitere Filterung des zugeführten und erfassten Spannungssignals versehen. Ein Digitalfilter ist beispielsweise durch einen entsprechenden Rechenalgorithmus in einer durch eine Rechenvorrichtung realisierten Teilauswertevorrichtung gebildet und damit besonders flexibel gestaltbar. Die erzielbaren Analyseergebnisse sind damit weiter verbessert.

Die Realisation von einer oder mehreren Teilauswertevorrichtungen durch eine Rechenvorrichtung wie einen Personalcomputer ist erfindungsgemäß besonders vorteilhaft aufgrund der hohen Flexibilität in der Programmierung einer derartigen Rechenvorrichtung. In diesem Falle bietet sich die Verwendung von A/D Wandlern für die jeweiligen Erfassungsvorrichtungen besonders an. Erfindungsgemäß stellt beispielsweise auch eine elektrische Schaltungsplatine mit programmierbarem EPROM eine Rechenvorrichtung dar.

In ebenso vorteilhafter Weise sind erfindungsgemäß mehrere Teilauswertevorrichtungen mittels einer gemeinsamen Rechenvorrichtung realisiert. Die erfindungsgemäßen Vorteile einer individuell getrennten Filterung und Erfassung eines Spannungssignals bleiben so einerseits erhalten und andererseits ist der Hardwareaufwand der Teilauswertungsvorrichtungen damit in vorteilhafter Weise reduziert. Bei der gemeinsamen Implementierung auf einer Rechenvorrichtung ist dann beispielsweise jede Teilauswertevorrichtung durch ein jeweiliges Softwareprogrammprodukt realisiert, welche dann parallel von der Rechenvorrichtung abgearbeitet werden.

Erfindungsgemäß sind in einer Ausgestaltung des erfindungsgemäßen Überwachungssystems auch weitere Teilauswertevorrichtungen vorgesehen, beispielsweise für die Ermittlung von Spitzenspannung, tan Δ und/oder höherfrequenten Überspannungen. Je nach relevantem Frequenzbereich für die jeweiligen Teilauswertevorrichtungen ist es bei mehreren Analyseaufgaben mit ähnlichen Frequenzanforderungen, beispielsweise eine Analyse der harmonischen Oberschwingungen und einer Analyse von einer 50Hz Überspannung möglich, diese durch ein und dieselbe Teilauswertevorrichtung durchführen zu lassen. Eine getrennte und individuell verschiedene Filterung des jeweiligen Spannungssignals ist in einem solchen Fall nicht zwangsläufig notwendig, so dass die Analyse- oder Auswertefunktionen zusammenfassbar sind.

Gemäß einer besonders bevorzugten Ausprägung des erfindungsgemäßen Überwachungssystems ist dieses in unmittelbarer Nähe des Transformators angeordnet, welcher zu überwachen ist, und beispielsweise auch mit dessen äußerem Gehäuse verbunden. Hierdurch sind ist die Länge der Verbindungsleitungen kurz gehalten womit einer eventuellen Verschlechterung der Analyseergebnisse durch Einkopplungen von Störspannungen in die Verbindungsleitungen vorgebeugt ist. Ein dauerhafter Einsatz der Überwachungsvorrichtung im Feld wird hierdurch auch vereinfacht.

Die erfindungsgemäße Aufgabe wird auch gelöst durch ein Verfahren zur kontinuierlichen Überwachung eines Leistungstransformators mit einem Überwachungssystem nach einem der Ansprüche 1 bis 14 mit folgenden Schritten:
- Kontinuierliches Messen von wenigstens einem Spannungssignal eines im Betrieb befindlichen Leistungstransformators über einen in einer jeweiligen Durchführungen des Transformators angeordneten Messwandler
- Kontinuierliches Zuführen des Spannungssignals zu wenigstens zwei unabhängigen Erfassungsvorrichtungen, wobei bei wenigstens einer Erfassungsvorrichtung ein individueller Analogfilter vorgeschaltet ist, durch welchen das Frequenzband des individuell zugeführten Spannungssignals individuell begrenzt wird
- Kontinuierliche Erfassung der jeweils gefiltert zugeführten Spannungssignale und Zuführung zu einer jeweiligen Teilauswertevorrichtung
- Kontinuierliche Ermittlung wenigstens eines jeweiligen Analysewertes je Teilauswertevorrichtung anhand wenigstens des jeweiligen Spannungssignals
- Kontinuierliche Bereitstellung des jeweils wenigstens einen Analysewertes

Die erfindungsgemäßen Vorteile eines solchen kontinuierlichen Überwachungsverfahrens entsprechen den zuvor genannten Vorteilen.

In einer weiteren Variante des erfindungsgemäßen Überwachungsverfahrens sind folgende zusätzliche Schritte vorgesehen:
- Kontinuierliche zeitlich korrelierte Auswertung von wenigstens zwei ermittelten Analysewerten von verschiedenen Teilauswertevorrichtung in einer weiteren Teilauswertevorrichtung
- Kontinuierliche Bereitstellung des daraus resultierenden Analysewertes

Auch hier wurden die erfindungsgemäßen Vorteile in den entsprechenden Unteransprüchen des Überwachungssystems bereits beschrieben, ebenso wie die Vorteile der Ausführungsvariante mit folgenden zusätzlichen Merkmalen:
- Kontinuierliches Messen von wenigstens drei Spannungssignalen eines im Betrieb befindlichen Leistungstransformators mittels jeweils eines in jeweils einer von drei Durchführungen des Transformators angeordneten Messwandlers
- Kontinuierliche zeitlich korrelierte Auswertung von wenigstens zwei kontinuierlich ermittelten Analysewerten in einer weiteren Teilauswertevorrichtung, welche ihrerseits durch eine jeweilige Teilauswertevorrichtung anhand in verschiedenen Durchführungen des Transformators gemessener Spannungssignale bestimmt werden
- Kontinuierliche Bereitstellung des daraus resultierenden Analysewertes

Weitere vorteilhafte Ausgestaltungsmöglichkeiten sind den weiteren abhängigen Ansprüchen zu entnehmen.

Anhand der in den Zeichnungen dargestellten Ausführungsbeispiele sollen die Erfindung, weitere Ausführungsformen und weitere Vorteile näher beschrieben werden.

Es zeigen:
- Fig. 1: einen Leistungstransformator mit einem ersten Überwachungssystem in einer ersten Ausgestaltung,
- Fig. 1a: einen Leistungstransformator mit einem ersten Überwachungssystem in zweiten ersten Ausgestaltung,
- Fig. 1b: einen Leistungstransformator mit einem ersten Überwachungssystem in dritten Ausgestaltung,
- Fig. 2: eine exemplarische Durchführung,
- Fig. 3: einen Leistungstransformator mit einem zweiten Überwachungssystem,
- Fig. 4: einen Leistungstransformator mit einem dritten Überwachungssystem,
- Fig. 5: einen exemplarischen Spannungsverlauf mit Oberschwingung und
- Fig. 6: einen exemplarischen Spannungsverlauf bei Teilentladung

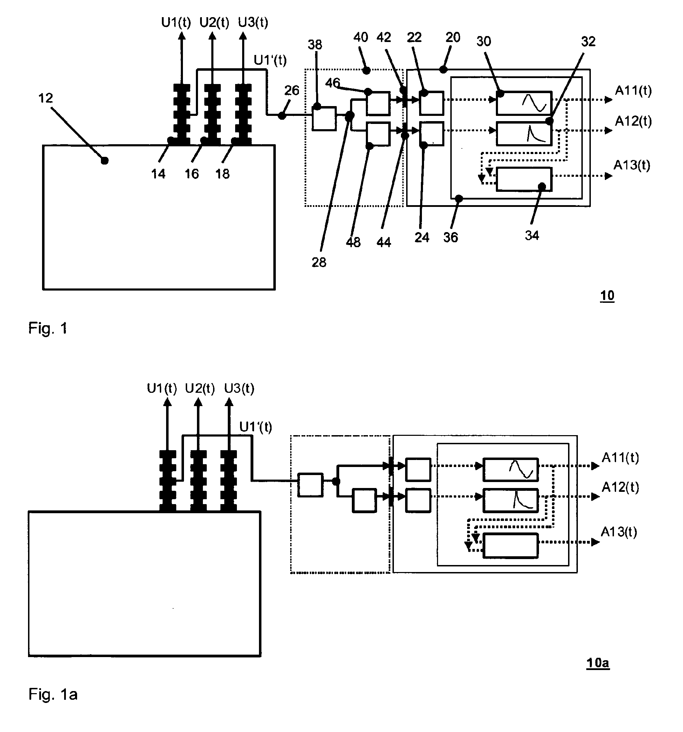

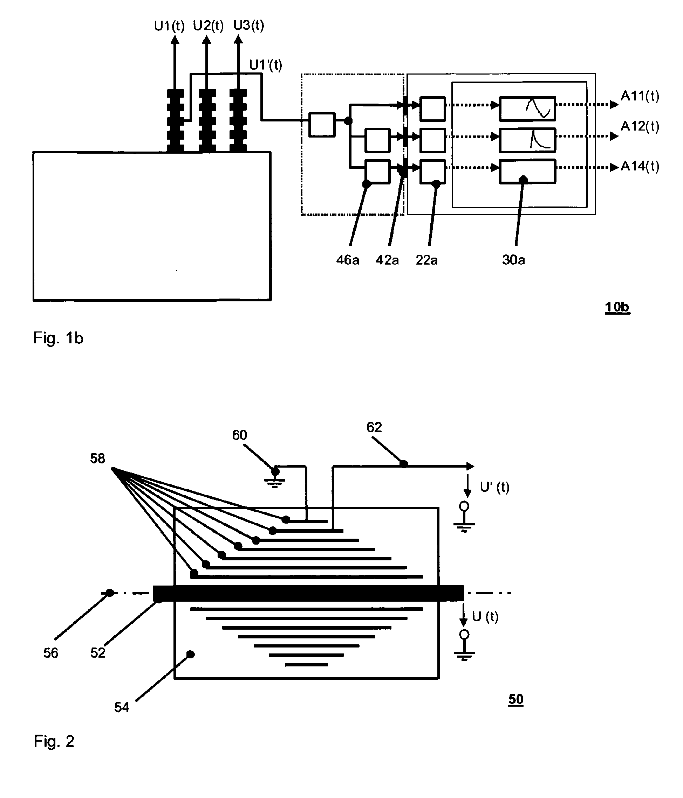

Fig. 1 zeigt einen Leistungstransformator 12 mit einem ersten Überwachungssystem in einer Darstellung 10. Drei oberspannungsseitige Anschlüsse des vereinfacht angedeuteten Leistungstransformators 12 sind mittels dreier Durchführungen 14, 16, 18 nach außen geleitet. Die im Wesentlichen symmetrischen Spannungen der drei Phasen sind durch die Bezeichnung U1(t), U2(t) und U3(t) angedeutet, wobei vorhandene unterspannungsseitige Anschlüsse in der Fig. nicht dargestellt sind. Die erste Durchführung 14 weist einen - nicht dargestellten - integrierten kapazitiven Spannungswandler auf, an dessen ebenfalls nicht gezeigtem Anschlusselement eine Verbindungsleitung 26 angeschlossen ist.

Die Verbindungsleitung 26 ist beispielsweise ein geschirmtes Koaxialkabel, welches an seinem transformatorfernen Ende in eine erste Signalanpassvorrichtung 38 geführt ist, welcher in diesem Fall somit die an dem Anschlusselement der ersten Durchführung 14 abgegriffenen Spannung U1'(t) zugeführt wird. In der ersten Signalanpassvorrichtung 38 wird die Amplitude der Spannung U1'(t) beispielsweise proportional auf einen Maximalwert von +/- 10V im fehlerfreien Fall abgeschwächt und an einem Ausgang bereitgestellt, der seinerseits über ein weiteres Stück der Verbindungsleitung 26 mit einer Abzweigung 28 verbunden ist, an der sich die Verbindungsleitung 26 teilt.

In Übertragungsrichtung nach der Abzweigung 28 sind zwei weitere Verbindungsleitungsstücke 26 zunächst jeweils in einen ersten 46 oder einen zweiten 48 Analogfilter geführt, durch welchen das jeweilige Frequenzband des jeweils an einen ersten 42 bzw. zweiten 44 Anschluss einer ersten Auswertevorrichtung 20 weitergeführten Spannungssignals individuell angepasst ist. Die Auswertevorrichtung 20 ist vorzugsweise in einem geschirmten Gehäuse untergebracht und weist zwei Erfassungsvorrichtungen 22, 24 für die individuell zugeführten Spannungssignale auf.

Die Auswertevorrichtung 20 dient dem Zweck, anhand des Spannungssignals U'(t) kontinuierlich Aussagen zu treffen bzw. Analysewerte A11(t), A12(t) und A13(t) bereitzustellen, welche eine Aussage über mögliche Fehler im Leistungstransformator 12 sowie dessen alterungstechnisch relevante Belastung beinhalten oder zumindest ermöglichen. Jeder Analysewert wird durch eine separate Teilauswertevorrichtung 30, 32 bzw. 34 ermittelt, wobei in diesem Beispiel der erste Analysewert A11(t) eine Aussage über Qualität und Quantität von eventuell vorhandenen harmonischen Oberschwingungen beinhaltet, beispielsweise eine sechste harmonische Oberschwingung mit einem Anteil von 11 % an einer Amplitude einer 50Hz Grundschwingung der Spannung U'(t).

Der zweite Analysewert A12(t) beinhaltet eine Aussage über die Qualität und Quantität von möglichen Teilentladungsvorgängen innerhalb des Leistungstransformators 12, wobei dieser in bestimmten Zeitintervallen, beispielsweise jede Sekunde, erneut ermittelt und am Ausgang der Auswertevorrichtung 20 beispielsweise in Form von digitalen Werten bereitgestellt wird.

Der ersten Teilauswertungsvorrichtung 30 ist somit ein angepasstes Eingangsspannungsignal U1'_1(t) zugeführt, welches sich aus der gemessenen Spannung U1'(t), einer nachfolgenden Amplitudenmodellierung durch die erste Anpassvorrichtung 38, einer Begrenzung des Frequenzbandes durch den ersten Analogfilter 46 und einer Erfassung durch die erste Erfassungsvorrichtung 22 ergibt. In günstiger Weise weist die erste Erfassungsvorrichtung 22 einen Analog- Digitalwandler auf, so dass das angepasste Eingangsspannungssignal U1'_1(t) letztendlich in Form von digitalen Werten vorliegt, welche kontinuierlich in einem bestimmten Zeitraum, beispielsweise mit einer Frequenz von 100kHz, aktualisiert werden.

Die erste Teilauswertung 30 dient wie zuvor erwähnt dem Zweck, eine Analyse der harmonischen Oberschwingungen der gemessenen Spannung U1'(t) bzw. der angepassten Spannung U1'_1(t) durchzuführen. Unter der Voraussetzung, dass maximal die hundertste harmonische Oberschwingung von Relevanz für eine Analyse ist, ergibt sich daraus bei einer Grundfrequenz der Netzspannung von 50Hz eine absolute Frequenz der hundertsten harmonischen Oberschwingung von 5kHz. Demgemäß ist es zweckmäßig, den ersten Analogfilter 46 derart zu dimensionieren, dass er zumindest einen Tiefpass für 5kHz, mit einer entsprechenden Sicherheit beispielsweise einen Tiefpass für 25kHz darstellt. Die Abtastfrequenz der nachfolgenden ersten Anpassvorrichtung bzw. des A/D Wandlers 22 beträgt nach dem Abtasttheorem wenigstens das Doppelte, besser das Vierfache der Grenzfrequenz von 25kHz, also 100kHz.

In entsprechender Weise ist der zweiten Teilauswertungsvorrichtung 32 ein ebenfalls angepasstes Eingangsspannungsignal U1'_2(t) zugeführt, welches sich aus der gemessenen Spannung U1'(t), einer nachfolgenden Amplitudenmodellierung durch die erste Anpassvorrichtung 38, einer Begrenzung des Frequenzbandes durch den zweiten Analogfilter 48 und einer Erfassung durch die zweite Erfassungsvorrichtung 24 ergibt, welche ebenfalls einen Analog- Digitalwandler umfasst.

Die zweite Teilauswertung 32 dient wie zuvor erwähnt dem Zweck, eine Teilentladungsanalyse der gemessenen Spannung U1'(t) bzw. der angepassten Spannung U1'_2(t) durchzuführen. Eine Teilentladung ist ein sehr hochfrequenter Vorgang, beispielsweise im MHz Bereich, so dass der zweite analoge Filter 48 als Hochpass mit einer Grenzfrequenz von einigen hundert kHz auszulegen ist. Somit ist gewährleistet, dass für die Teilentladungsmessung keine irrelevanten Anteile des Spannungssignals verwendet werden, welche das Analyseergebnis verfälschen.

Die Analysewerte A11(t) und A12(t) der ersten 30 und zweiten 32 Teilauswertvorrichtung werden beide kontinuierlich ermittelt und zum Zwecke einer zeitlich korrelierten Auswertung einer dritten Teilauswertevorrichtung 34 zur Verfügung gestellt, beispielsweise als digitale Werte.

Alle drei Teilauswertevorrichtungen 30, 32, 34 sind in Form jeweils eines Algorithmus bzw. in einem jeweiligen Programmprodukt, durch welchen der jeweilige Algorithmus dargestellt ist, auf ein und derselben ersten Rechenvorrichtung 36 realisiert. Die dritte Teilauswertungsvorrichtung 34 umfasst jedoch komplexere Algorithmen und bildet beispielsweise auch Strukturen eines Expertensystems zur Entscheidungsfindung ab. Dementsprechend sind dessen Analysewerte A13(t) auch komplexer als A11(t) und A12(t) und umfassen gegebenenfalls auch weitergehende Angaben über Ort und Ursache eines möglichen Fehlers oder auch eine Warnung für einen unmittelbar bevorstehenden Fehler. Deren kontinuierliche Bereitstellung erfolgt daher in diesem Beispiel in längeren Zeitintervallen als die Bereitstellung der Analysewerte A11(t) oder A12(t), beispielsweise auch nur alle 30min oder auch selektiv nur bei Vorhandensein eines analysierten Transformatorfehlers oder einer sonstigen Abnormalität.

Selbstverständlich sind auch weitere - nicht dargestellte - Erfassungsvorrichtungen für weitere Messsignale vorgesehen, welche keine Spannungssignale darstellen. So ist beispielsweise zur Ermittlung eines Verlustfaktors, einer tan Δ Messung, zusätzlich die kontinuierliche Zuführung wenigstens eines Stromsignals zur Auswertevorrichtung 20 notwendig, welches dann ebenfalls beispielsweise mittels eines A/D Wandlers zu erfassen und dann einer entsprechenden Teilauswertevorrichtung zuzuführen ist. Aufgrund der physikalischen Tatsache, dass ein Stromwert an Induktivitäten nicht springen kann ist jedoch die Problematik einer individuellen Filterung des Stromsignals nicht von so hoher Bedeutung wie bei einem Spannungssignal.

Fig. 1a zeigt denselben Transformator wie Fig. 1 mit denselben Bezugszeichen, in diesem Fall ist jedoch der erste Analogfilter der ersten Auswertevorrichtung entfallen. Dies ist beispielsweise - wie in diesem Fall - bei einer Analyse im Frequenzbereich von 50Hz - einigen 100Hz möglich, sofern die nachfolgende Teilauswertevorrichtung über einen integrierten Digitalfilter mit Tiefpasscharakter verfügt. Die erfindungsgemäßen Vorteile werden dennoch durch den zweiten Analogfilter in der parallel verlaufenden Übertragungskette erreicht.

Fig. 1 b zeigt denselben Transformator wie Fig. 1 mit denselben Bezugszeichen, hier ist jedoch neben dem Entfall des ersten Analogfilters entsprechend Fig. 1a eine weitere Signalübertragungskette mit einem weiteren Analogfilter 46a und einer weiteren Erfassungsvorrichtung 22a vorgesehen, welche ein entsprechend individuell angepasstes Spannungssignal einer weiteren Teilauswertevorrichtung 30a bereitstellt. Diese führt eine Spannungssignalanalyse in einem höherfrequenten Bereich von Beispielsweise >50kHz ... <300kHz durch.

Fig. 2 stellt eine exemplarische Durchführung eines Leistungstransformators in einer Schnittdarstellung 50 dar. Längs einer Rotationsachse 56 verläuft ein zylinderförmiger elektrischer Leiter 52, welcher ein elektrisches Windungsende einer nicht gezeigten Transformatorwicklung durch ein nicht gezeigtes Transformatorgehäuse nach außen verbindet. Schalenförmig um den Leiter 52 und die Rotationsachse 56 angeordnet sind mehrere radial äquidistant beabstandete Lagen 58 eines elektrischen Bandleiters, deren axiale Länge mit steigendem Radius reduziert ist. Diese Lagen dienen sowohl dem Zweck der Potentialsteuerung, bilden aber gleichzeitig auch einen integrierten kapazitiven Spannungsteiler. Die radial äußerste Lage ist mittels einer Erdung 60 auf Erdpotential gelegt, die zweitäußerste ist mit einer Ausgangsleitung 62 verbunden, welche einen Anschluss an den kapazitiven Spannungsteiler bildet. Die dort anliegende Messspannung U'(t) ist direkt proportional zur gemessenen Spannung U(t).

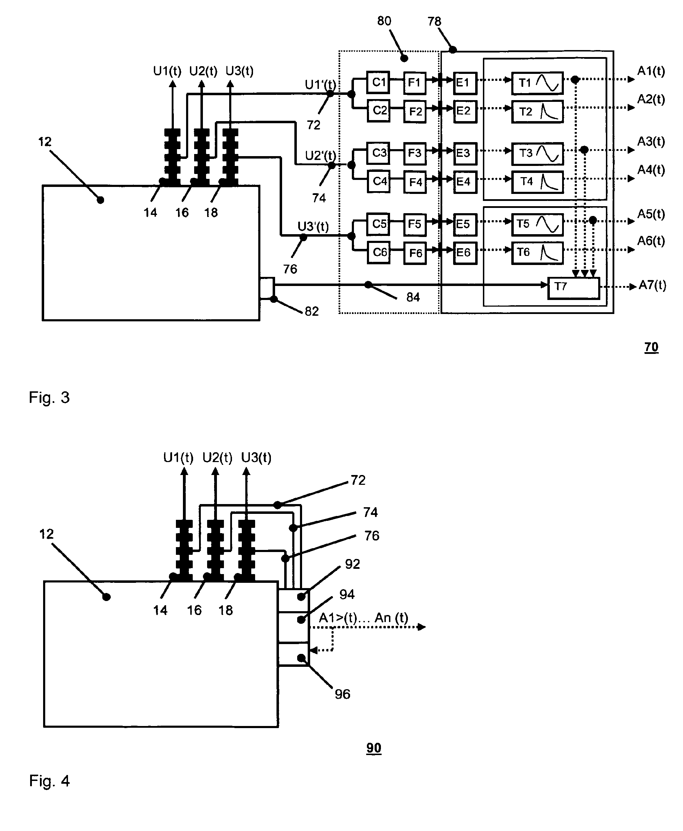

Fig. 3 stellt einen Leistungstransformator mit einem zweiten Überwachungssystem in einer Darstellung 70 dar. Der Leistungstransformator 12 entspricht dem Leistungstransformator aus der Fig. 1, in diesem Beispiel werden aber alle drei Durchführungen 14, 16. 18 bezüglich ihrer Spannungen U1(t), U2(t), U3(t) durch ein zweites exemplarisches Überwachungssystem kontinuierlich überwacht. Jeweils in den Durchführungen 14, 16, 18 integrierte kapazitive Spannungsteiler erzeugen jeweils eine zu den ursprünglichen Spannungen proportionale Spannung U1'(t), U2'(t), U3'(t), welche über jeweilige Verbindungsleitungen 72, 74, 76 in einen zweiten Anpassbereich 80 geführt sind.

Dieser Anpassbereich 80 ist lokal nicht scharf umgrenzt, er beschreibt vielmehr einen Bereich, in welchem eine jeweilige Abzweigung, Anpassvorrichtungen C1, C2, C3, C4, C5, C6 und/oder Analogfilter F1, F2, F3, F4, F5, F6 angeordnet sind, welche den Verbindungsleitungen 72, 74, 76 zwischengeschaltet sind, wobei die Verbindungsleitungen 72, 74, 76 letztendlich in eine zweite Auswertevorrichtung 78 geführt sind. Es kann einerseits zweckmäßig sein, diesen Anpassbereich 80 in ummittelbarer Nähe zur zweiten Anpassvorrichtung 78 anzuordnen, welche funktionell der in der Fig. 1 dargestellten ersten Anpassvorrichtung 20 ähnlich ist, aber im Unterschied dazu dreiphasig aufgebaut ist. In diesem Fall ist sind die Verbindungsleitungen 72, 74, 76 beispielsweise durch ein geschirmtes Koaxialkabel realisiert. Es ist unter Umständen aber auch zweckmäßig, den Anpassbereich 80 in unmittelbarer Nähe zu den Durchführungen 14, 16, 18 anzuordnen wobei beispielsweise den Analogfiltern F1, F2, F3, F4, F5, F6 bereits im zweiten Anpassbereich 80 ein Analog- Digitalwandler mit einer jeweils zugeordneten optischen Umwandlungsvorrichtung, beispielsweise einem Laser mit zugehöriger Steuereinheit, nachgeschaltet ist. In diesem Fall wird die räumliche Distanz zwischen Anpassbereich 80 und zweiter Auswertevorrichtung mit jeweils abschnittsweise als Glasfaserkabel ausgeführten Verbindungsleitungen 72, 74, 76 überbrückt.

Die jeweiligen Anpassvorrichtungen C1, C2, C3, C4, C5, C6 sind längs der Übertragungsrichtung der Verbindungsleitungen 72, 74, 76 erst nach den jeweiligen Abzweigungen angeordnet, so dass die Möglichkeit einer individuellen Spannungssignalanpassung, beispielsweise einer Amplitudenmodellierung, besteht.

Die zweite Anpassvorrichtung 78 umfasst in diesem Beispiel eine Gruppe von jeweils drei ersten Erfassungsvorrichtungen E1, E3, E5 mit direkt zugeordneten Teilauswertevorrichtungen T1, T3, T5, sowie eine Gruppe mit jeweils drei zweiten Erfassungsvorrichtungen E2, E4, E6 mit direkt zugeordneten Teilauswertevorrichtungen T2, T4, T6. Deren Funktionsweise entspricht der Funktionsweise der entsprechenden Teilauswertevorrichtungen aus der zuvor beschriebenen Fig., der wesentliche unterschied besteht hier in der Dreiphasigkeit.

Das Spannungssignal U1'(t) wird also über eine erste Signalübertragungskette u.a. mit den Komponenten erste Anpassvorrichtung C1, erster Analogfilter F1, erste Erfassungsvorrichtung E1 individuell angepasst der ersten Teilauswertevorrichtung T1 zugeführt, welche kontinuierlich einen ersten Analysewert A1(t) ermittelt, welcher in diesem Beispiel Aussagen bezüglich der harmonischen Oberschwingungen beinhaltet.

Das Spannungssignal U1'(t) wird zudem über eine zweite Signalübertragungskette u.a. mit den Komponenten zweite Anpassvorrichtung C2, zweiter Analogfilter F2, zweite Erfassungsvorrichtung E2 individuell angepasst der zweiten Teilauswertevorrichtung T2 zugeführt, welche kontinuierlich einen ersten Analysewert A2(t) ermittelt, welcher in diesem Beispiel Aussagen bezüglich eventueller Teilentladungen beinhaltet. Selbstverständlich sind auch mehr als zwei individuelle Signalübertragungsketten denkbar.

Die Spannungssignale U2'(t) und U3'(t) werden in entsprechender Weise ausgewertet, wobei deren Analyseergebnisse den Analysewerten A3(t), A4(t), A5(t) und A6(t) zu entnehmen sind. Eine siebte Teilauswertevorrichtung T7 wertet jeweils die Ergebnisse A1(t), A3(t), A5(t) der ersten Teilauswertevorrichtungen T1, T3, T5 in einer zeitlichen Korrelation aus und stellt die Ergebnisse hieraus in den Analysewerten A7(t) zur Verfügung. Durch den Quervergleich zwischen den Analysewerten von drei verschiedenen Phasen ist sind zusätzliche Informationen über den Zustand des Leistungstransformators 12 gewinnbar.

In der Fig. zusätzlich gezeigt ist noch ein Vibrationsmesser 82, welcher eine eventuelle Vibration an einem Außenbereich des Leistungstransformators 12 aufnimmt und ebenfalls der siebten Teilauswertevorrichtung T7 zuführt. Somit ist zusätzlich neben der Korrelation der Analysewerte der drei Phasen noch eine Korrelation zu einer abnormalen Vibration des Leistungstransformators 12 ermöglicht. Auch hierdurch ist in vorteilhafter Weise eine zusätzliche, verbesserte Information über den Zustand des Leistungstransformators 12 gewinnbar.

Optional werden die Analyseergebnisse A1(t) ... A7(t) komplett oder auch nur teilweise in einer nicht gezeigten Datenspeichervorrichtung abgelegt, welche beispielsweise die Analysewerte von einem Zeitraum von mehreren Tagen oder auch Monaten speichert.

Fig. 4 zeigt einen Leistungstransformator mit einem dritten Überwachungssystem, welcher auch bezüglich der verwendeten Bezugszeichen im Prinzip dem aus der zuvor gezeigten Fig. entspricht. Mit Verbindungsleitungen 72, 74, 76 werden Spannungssignale aus in den Durchführungen 14, 16, 18 integrierten kapazitiven Spannungswandlern in einen dritten Anpassbereich 92 geführt, welcher beispielsweise nicht gezeigte Signalanpassvorrichtungen und Analogfilter umfasst. Dieser ist vorzugsweise zusammen mit einer dritten Auswertevorrichtung 94 und einer Speichervorrichtung 96 in einem gemeinsamen geschirmten Gehäuse direkt und durchführungsnah am Leistungstransformator 12 angeordnet. Die Speichervorrichtung 96 speichert die Analysewerte An(t) der Analysevorrichtung 94 über einen bestimmten Zeitraum. Die Anordnung eines derartigen gemeinsamen Gehäuses an dem Leistungstransformator 12 erweist sich als vorteilhaft, weil so lange Übertragungswege der jeweiligen Spannungssignale vermieden sind. Auch ist ein solches Überwachungssystem als Teil eines Leistungstransformators zu verstehen und von dessen Hersteller auch besonders einfach direkt zusammen mit diesem auszuliefern.

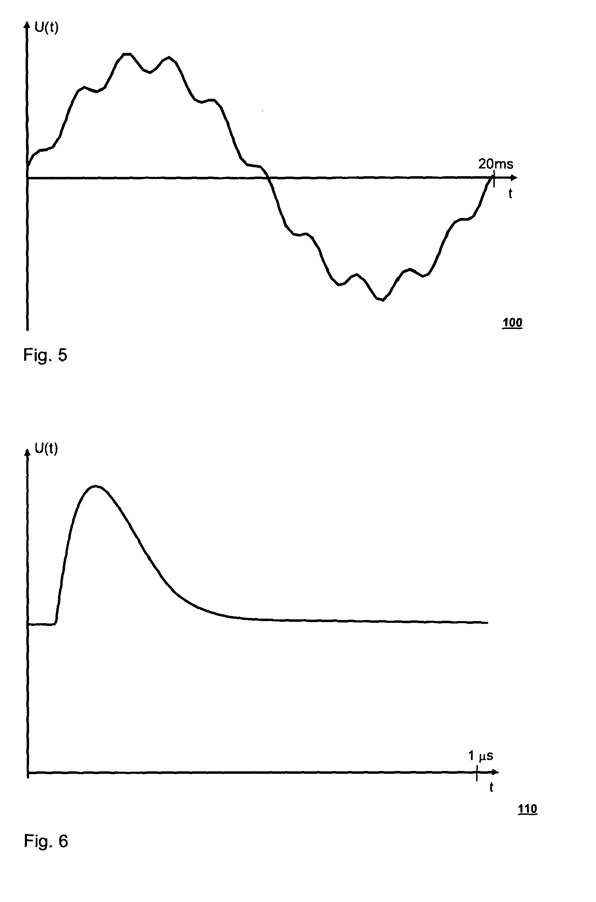

Fig. 5 zeigt in einer Darstellung 100 einen Verlauf eines periodischen sinusförmigen Spannungssignals mit überlagerter 10. harmonischer Oberschwingung, wobei eine Periode bei einer Netzfrequenz von 50Hz genau 20ms umfasst.

Fig. 6 zeigt in einer Darstellung 110 einen Verlauf eines sinusförmigen Spannungssignals mit überlagertem Teilentladungsimpuls. Der zeitliche Maßstab ist hier jedoch deutlich gestreckt, um den Teilentladungsimpuls mit seiner zeitlichen Länge von wenigen µs deutlich sichtbar zu machen. Der Verlauf des sinusförmigen Spannungssignals ist daher nur mit einem Bruchteil seiner Länge von 20ms dargestellt, so dass er in dieser Darstellung als zeitlich konstanter Grundwert erscheint.

### Bezugszeichenliste

- 10: Leistungstransformator mit erstem Überwachungssystem in erster Ausfüh- rungsform
- 10a: Leistungstransformator mit erstem Überwachungssystem in zweiter Aus- führungsform
- 10b: Leistungstransformator mit erstem Überwachungssystem in dritter Ausfüh- rungsform
- 12: Leistungstransformator
- 14: erste Durchführung
- 16: zweite Durchführung
- 18: dritte Durchführung
- 20: erste Auswertevorrichtung
- 22: erste Erfassungsvorrichtung
- 22a: weitere Erfassungsvorrichtung
- 24: zweite Erfassungsvorrichtung
- 26: Verbindungsleitung
- 28: Abzweigung der Verbindungsleitung
- 30: erste Teilauswertevorrichtung
- 30a: weitere Teilauswertevorrichtung
- 32: zweite Teilauswertevorrichtung
- 34: dritte Teilauswertevorrichtung
- 36: erste Rechenvorrichtung
- 38: erste Signalanpassvorrichtung
- 40: erster Anpassbereich der Verbindungsleitung
- 42: erster Anschluss der Auswertevorrichtung
- 42a: weiterer Anschluss der Auswertevorrichtung
- 44: zweiter Anschluss der Auswertevorrichtung
- 46: erster Analogfilter
- 46: weiterer Analogfilter
- 48: zweiter Analogfilter
- 50: vierte Durchführung
- 52: elektrischer Leiter
- 54: Durchführungsgehäuse
- 56: Rotationsachse
- 58: integrierter kapazitiver Spannungsteiler
- 60: Erdung
- 62: Ausgangsleitung des kapazitiven Spannungsteilers
- 70: Leistungstransformator mit zweitem Überwachungssystem
- 72: zweite Verbindungsleitung
- 74: dritte Verbindungsleitung
- 76: vierte Verbindungsleitung
- 78: zweite Auswertevorrichtung
- 80: zweiter Anpassbereich der Verbindungsleitungen
- 82: Vibrationssensor
- 84: fünfte Verbindungsleitung
- 90: Leistungstransformator mit drittem Überwachungssystem
- 92: dritter Anpassbereich der Verbindungsleitungen
- 94: dritte Auswertevorrichtung
- 96: Speichervorrichtung
- 100: exemplarischer Spannungsverlauf mit Oberschwingung
- 110: exemplarischer Spannungsverlauf bei Teilentladung

- C1, C3, C5: erste Anpassvorrichtung
- C2, C4, C6: zweite Anpassvorrichtung
- F1, F3, F5: erster Analogfilter
- F2, F4, F6: zweiter Analogfilter
- E1, E3, E5: erste Erfassungsvorrichtung
- E2, E4, E6: zweite Erfassungsvorrichtung
- U1'(t), U2'(t), U3'(t): Spannungssignal
- U1'_1(t), U1'_2(t),: angepasstes und erfasstes Spannungssignal
- A1(t) ... A13(t): Analysewert

## Patentansprüche

1. Überwachungssystem für Leistungstransformatoren (12), mit wenigstens einer Messvorrichtung (58) zur kontinuierlichen Erfassung eines Spannungssignals (U'(t), U1'(t), U2'(t), U3'(t), 100, 110), welche in einer Durchführung (14, 16, 18, 50) des Leistungstransformators (12) integriert ist, mit wenigstens einer Auswertevorrichtung (20, 78, 94) zur Analyse wenigstens des Spannungssignals (U'(t), U1'(t), U2'(t), U3'(t), 100, 110), **dadurch gekennzeichnet, dass** die Auswertevorrichtung (20, 78, 94) wenigstens eine erste (22, E1, E3, E5) und eine zweite (24, E2, E4, E6) unabhängige Erfassungsvorrichtung für das dieser über wenigstens eine Verbindungsleitung (26, 72, 74, 76) jeweils zugeführte Spannungssignal (U'(t), U1'(t), U2'(t), U3'(t), 100, 110) aufweist, dass wenigstens eine erste Teilauswertevorrichtung (30, T1, T3, T5) für eine Spannungssignalanalyse in einem ersten Frequenzbereich mit der ersten Erfassungsvorrichtung (22, E1, E3, E5) verbunden ist, dass wenigstens eine zweite Teilauswertevorrichtung (32, T2, T4, T6) für eine Spannungssignalanalyse in einem zweiten Frequenzbereich mit der zweiten Erfassungsvorrichtung (24, E2, E4, E6) verbunden ist und dass in der Verbindungsleitung (26, 72, 74, 76) wenigstens eine Abzweigung (28) mit nachgeschaltetem Analogfilter (46, 48, F1, F2, F3, F4, F5, F6) vorgesehen ist, welche das jeweilige Frequenzband des der jeweiligen Erfassungsvorrichtung (22, 24, E1, E2, E3, E4, E5, E6) zugeführten Spannungssignals (U'(t), U1'(t), U2'(t), U3'(t), 100, 110) individuell begrenzt.

2. Überwachsungssystem nach Anspruch 1, **dadurch gekennzeichnet, dass** jeder Erfassungsvorrichtung (22, 24, E1, E2, E3, E4, E5, E6) jeweils ein individueller Analogfilter (46, 48, F1, F2, F3, F4, F5, F6) zugeordnet ist, welcher das jeweilige Frequenzband des jeweils zugeführten Spannungssignals (U'(t), U1'(t), U2'(t), U3'(t), 100, 110) individuell begrenzt

3. Überwachungssystem nach einem der Ansprüche 1 oder 2, **dadurch gekennzeichnet, dass** wenigstens eine der Erfassungsvorrichtungen (22, 24, E1, E2, E3, E4, E5, E6) einen Analog- Digitalwandler aufweist.

4. Überwachungssystem nach einem der vorangegangenen Ansprüche, **dadurch gekennzeichnet, dass** die erste Teilauswertevorrichtung (30, T1, T3, T5) wenigstens für eine Analyse der harmonischen Oberschwingungen vorgesehen ist und der zugehörige Analogfilter (46, F1, F3, F5) einen Bandpass für etwa 1 kHz bis 50kHz darstellt.

5. Überwachungssystem nach einem der vorangegangenen Ansprüche, **dadurch gekennzeichnet, dass** die zweite Teilauswertevorrichtung (32, T2, T4, T6) wenigstens für eine Teilentladungs-Analyse vorgesehen ist und der zugehörige Analogfilter (48, F2, F4, F6) einen Bandpass für etwa 100kHz bis 2MHz darstellt.

6. Überwachsungssystem nach einem der vorangegangenen Ansprüche, **dadurch gekennzeichnet, dass** in der Verbindungsleitung (26, 72, 74, 76) wenigstens eine Signalanpassvorrichtung (38, C1, C2) zwischengeschaltet ist.

7. Überwachsungssystem nach einem der vorangegangenen Ansprüche, **dadurch gekennzeichnet, dass** die Ergebnisse von wenigstens zwei Teilauswerteeinrichtungen (30, 32, T1, T3, T5) einer weiteren Teilauswertevorrichtung (34, T7) bereitgestellt sind und diese dafür vorgesehen ist, die Ergebnisse in einer zeitlichen Korrelation auszuwerten.

8. Überwachsungssystem nach Anspruch 7, **dadurch gekennzeichnet, dass** der weiteren Teilauswertevorrichtung (34, T7) zusätzlich ein Messsignal einer weiteren Messvorrichtung (82) zur Auswertung bereitgestellt ist, welches den zeitlichen Verlauf einer nicht-spannungsbezogenen Messgröße beschreibt.

9. Überwachsungssystem nach einem der vorangegangenen Ansprüche, **dadurch gekennzeichnet, dass** dieses mehrfach für jeweils verschiedene Phasen des Drehstromnetzes ausgeführt ist.

10. Überwachsungssystem nach einem der vorangegangenen Ansprüche, **dadurch gekennzeichnet, dass** wenigstens eine Teilauswertevorrichtung (30, 32, 34, T1, T2, T3, T4, T5, T6) zusätzlich mit wenigstens einem Digitalfilter für eine weitere Filterung des zugeführten und erfassten Spannungssignals versehen ist.

11. Überwachsungssystem nach einem der vorangegangenen Ansprüche, **dadurch gekennzeichnet, dass** wenigstens eine Teilauswertevorrichtung (30, 32, 34, T1, T2, T3, T4, T5, T6, T7) mittels einer Rechenvorrichtung realisiert ist.

12. Überwachsungssystem nach Anspruch 11, **dadurch gekennzeichnet, dass** mehrere Teilauswertevorrichtungen (30, 32, 34, T1, T2, T3, T4, T5, T6, T7) mittels einer gemeinsamen Rechenvorrichtung realisiert sind.

13. Überwachsungssystem nach einem der vorangegangenen Ansprüche, **dadurch gekennzeichnet, dass** weitere Teilauswertevorrichtungen (30, 32, 34, T1, T2, T3, T4, T5, T6, T7) vorgesehen sind für die Ermittlung von Spitzenspannung, tan Δ und/oder höherfrequenten Überspannungen.

14. Überwachungssystem nach einem der vorangegangenen Ansprüche, **dadurch gekennzeichnet, dass** verschiedene Analysen von ein und derselben Teilauswertevorrichtung (30, 32, 34, T1, T2, T3, T4, T5, T6, T7) durchführbar sind.

15. Transformator (12) mit einem Überwachungssystem nach einem der Ansprüche 1 bis 14, **dadurch gekennzeichnet, dass** das Überwachungssystem in unmittelbarer Nähe des Transformators (12) angeordnet ist.

16. Verfahren zur kontinuierlichen Überwachung eines Leistungstransformators mit einem Überwachungssystem nach einem der Ansprüche 1 bis 14 mit folgenden Schritten:
• Kontinuierliches Messen von wenigstens einem Spannungssignal (U'(t), U1'(t), U2'(t), U3'(t), 100, 110) eines im Betrieb befindlichen Leistungstransformators (12) über einen in einer jeweiligen Durchführungen (14, 16, 18, 50) des Transformators angeordneten Messwandler (58)
• Kontinuierliche Zuführen des Spannungssignals (U'(t), U1'(t), U2'(t), U3'(t), 100, 110) zu wenigstens zwei unabhängigen Erfassungsvorrichtungen (22, 24, E1, E2, E3, E4, E5, E6), wobei bei wenigstens einer Erfassungsvorrichtung ein individueller Analogfilter (46, 48, F1, F2, F3, F4, F5, F6) vorgeschaltet ist, durch welchen das Frequenzband des individuell zugeführten Spannungssignals individuell begrenzt wird
• Kontinuierliche Erfassung der jeweils gefiltert zugeführten Spannungssignale und Zuführung zu einer jeweiligen Teilauswertevorrichtung (30, 32, T1, T2, T3, T4, T5, T6)
• Kontinuierliche Ermittlung wenigstens eines jeweiligen Analysewertes (A1(t), A2(t), A3(t), A4(t) A5(t), A6(t), A11(t), A12(t)) je Teilauswertevorrichtung (30, 32, T1, T2, T3, T4, T5, T6) anhand wenigstens des jeweiligen Spannungssignals (U'(t), U1'(t), U2'(t), U3'(t), 100, 110)
• Kontinuierliche Bereitstellung des jeweils wenigstens einen Analysewertes (A1(t), A2(t), A3(t), A4(t) A5(t), A6(t), A11(t), A12(t))

17. Verfahren zur kontinuierlichen Überwachung eines Leistungstransformators nach Anspruch 16, **gekennzeichnet durch** wenigstens einen der folgenden zusätzlichen Schritte:
• Kontinuierliche digitale Filterung eines einer Teilauswertevorrichtung zugeführten und bereits individuell anlog gefilterten vor der Ermittlung des jeweils wenigstens einen Analysewertes (A1(t), A2(t), A3(t), A4(t) A5(t), A6(t), A11(t), A12(t))
• Kontinuierliche zeitlich korrelierte Auswertung von wenigstens zwei ermittelten Analysewerten (A11(t) , A12(t)) von verschiedenen Teilauswertevorrichtung (30, 32) in einer weiteren Teilauswertevorrichtung (34)
• Kontinuierliche Bereitstellung des daraus resultierenden Analysewertes (A13(t))

18. Verfahren zur kontinuierlichen Überwachung eines Leistungstransformators nach einem der Ansprüche 16 oder 17, **gekennzeichnet durch** wenigstens einen der folgende zusätzliche Schritte:
• Kontinuierliches Messen von wenigstens drei Spannungssignalen (U'(t), U1'(t), U2'(t), U3'(t), 100, 110) eines im Betrieb befindlichen Leistungstransformators (12) mittels jeweils eines in jeweils einer von drei Durchführungen (14, 16, 18, 50) des Transformators (12) angeordneten Messwandlers (58)
• Kontinuierliche zeitlich korrelierte Auswertung von wenigstens zwei kontinuierlich ermittelten Analysewerten (A1(t), A3(t), A5(t)) in einer weiteren Teilauswertevorrichtung (T7), welche ihrerseits **durch** eine jeweilige Teilauswertevorrichtung (T1, T3, T5) anhand in verschiedenen Durchführungen des Transformators gemessener Spannungssignale bestimmt werden.
• Kontinuierliche Bereitstellung des daraus resultierenden Analysewertes (A7(t))
